Europäisches Patentamt

(19) European Patent Office

Office européen des brevets

(11) EP 0 327 044 B2

(12) **NEUE EUROPÄISCHE PATENTSCHRIFT**

(45) Veröffentlichungstag und Bekanntmachung des Hinweises auf die Entscheidung über den Einspruch:
**22.04.1998 Patentblatt 1998/17**

(51) Int. Cl.⁶: **C04B 35/00**, H01L 39/24

(45) Hinweis auf die Patenterteilung:
**07.12.1994 Patentblatt 1994/49**

(21) Anmeldenummer: **89101689.1**

(22) Anmeldetag: **01.02.1989**

(54) **Supraleiter und Verfahren zu seiner Herstellung**

Superconductor and process for its production

Supraconducteur et procédé pour sa fabrication

(84) Benannte Vertragsstaaten:
**AT BE CH DE ES FR GB GR IT LI LU NL SE**

(30) Priorität: **05.02.1988 DE 3803530**
**29.02.1988 DE 3806417**
**29.02.1988 DE 3806530**
**01.03.1988 DE 3806531**

(43) Veröffentlichungstag der Anmeldung:
**09.08.1989 Patentblatt 1989/32**

(73) Patentinhaber:
**HOECHST AKTIENGESELLSCHAFT**
**65926 Frankfurt am Main (DE)**

(72) Erfinder:
• **Schnering, Hans-Georg, Prof.Dr.**
**D-7031 Aidlingen (DE)**
• **Becker, Winfried, Dr.**
**D-6233 Kelkheim (Taunus) (DE)**
• **Schwarz, Martin, Dr.**
**D-6240 Königstein/Taunus (DE)**
• **Hettich, Bernhard, Dr.**
**D-6238 Hofheim am Taunus (DE)**
• **Hartweg, Martin, Dr.**
**D-7000 Stuttgart (DE)**
• **Walz, Leonhard, Dr.**
**D-7550 Rastatt (DE)**
• **Popp, Thomas**
**D-7250 Leonberg (DE)**

(56) Entgegenhaltungen:
**EP-A- 332 291          EP-A- 0 330 305**

• **ZEITSCHRIFT FÜR PHYSIK B, CONDENSED MATTER, Band 68, Juli/August 1987, Seiten421-423, Springer Verlag; C. MICHEL et al.: "Superconductivity in the Bi-Sr-Cu-O system"**
• **APPLIED PHYSIC LETTERS, Band 51, Nr. 12, 21. September 1987, Seiten 943-945; S. JIN et al.: "Fabrication of dense Ba2YCu3O7-8 superconductor wire by molten oxide processing"**
• **Chemical and Engineering News, S.5 (01/02/88).**
• **M.A. SUBRAMANIAN et al., Science, Bd. 239, S. 1015-17 (26/02/88).**
• **Superconductor Week, Vol. 2, No. 6, (08/02/88).**
• **Japanese Economic News (22/01/88).**
• **Asahi Shinbun, S.3 (22/01/88).**
• **H. MAEDA et al., Jap. J. Appl. Phys. 1988, L209, 210 (20/02/88).**
• **Superconductor Week, Bd. 2, No. 5 (01/02/88).**
• **NIKKEI SUPERCONDUCTORS Nr.2, P.1, NIKKEI MCGRAW-HILL (25.01.88)**
• **NIKKEI SUPERCONDUCTORS Nr.3, P.2,3, NIKKEI MCGRAW-HILL (08.02.88)**
• **NIKKEI SUPERCONDUCTORS Nr.2, P.1, NIKKEI MCGRAW-HILL (22.02.88)**
• **JAPANESE JOURNAL OF APPLIED PHYSICS, vol.27, No.2, P.L209-L210 (26.02.88)**
• **JAPANESE JOURNAL OF APPLIED PHYSICS, vol.27, No.3, P.L344-L346 (26.02.88)**

EP 0 327 044 B2

EP 0 327 044 B2

**Beschreibung**

Die vorliegende Erfindung betrifft Hochtemperatur-supraleitende Substanzen auf Basis von Wismut, Strontium, Calcium und Kupfer.

Während die konventionellen supraleitenden Materialien ausschließlich bei sehr tiefen Temperaturen eingesetzt werden konnten, die den Einsatz des sehr teuren Kühlmittels Helium erforderten, arbeiten die neuen supraleitenden oxidischen Substanzen bei wesentlich höheren Temperaturen, die mit dem vergleichsweise billigen Kühlmittel Stickstoff erreichbar sind. Hierdurch verringern sich die Betriebskosten supraleitender Geräte und Anlagen und eröffnen neue, umfassende Anwendungsmöglichkeiten.

Ein wesentlicher Nachteil vieler neuer oxidischer Supraleiter besteht allerdings darin, daß sie als eine gemeinsame Komponente La oder Y oder Seltenerdmetalle wie z.B. Sm, Lu, Ho oder Eu enthalten. Diese Metalle kommen zum Teil nur in geringen Mengen vor und sind wegen ihrer aufwendigen Gewinnung teuer. Für die Herstellung großer Mengen oxidischer Supraleiter ergeben sich somit Nachteile aus den hohen Rohstoffpreisen und den begrenzten Resourcen der Seltenerdmetalle.

Es ist bereits ein oxidischer Supraleiter mit einer Sprungtemperatur von 20 K bekannt, der in oxidischer Form die Elemente Wismut, Strontium und Kupfer im Atomverhältnis 1:1:1 enthält. (C. Michel et al., Z. Phys. B 68 (1987) 421). Eine Sprungtemperatur von etwa 20 K ist für technische Zwecke jedoch noch nicht zufriedenstellend.

Hier brachten die Arbeiten von Maeda einen Fortschritt, dem es gelang, durch gleichzeitige Verwendung von Calcium und Strontium die Sprungtemperatur auf etwa 105 K zu erhöhen. (Jap. Economic News vom 22.1.88).

Ein Atomverhältnis Bi:Ca:Sr:Cu von 1:1:1:2 wurde in Asahi Shinbun, Seite 3 vom 22.1.88 erwähnt. Detaillierte experimentelle Angaben hierzu sind enthalten in H. Maeda et al., Jap. J. Appl. Phys. 1988, L. 209 vom 20.2.88 und in der nachveröffentlichten europäischen Patentanmeldung EP-A-0 330 305.

Es bestand daher die Aufgabe, neue supraleitende oxidische Stoffe und nach Möglichkeit definierte Verbindungen bereitzustellen, die ebenfalls keine seltenen Erdmetalle und kein Lanthan oder Yttrium enthalten und deren Sprungtemperatur mindestens 60K beträgt.

Gegenstand der Erfindung sind Stoffe mit Supraleitfähigkeit, die die Metalle Strontium, Calcium, Kupfer und Wismut in oxidischer Form in bestimmten Atomverhältnissen enthalten, sowie Verfahren zu ihrer Herstellung. Die Substanzen besitzen eine kritische Temperatur (Sprungtemperatur) $T_c$ von mindestens 60 K und vorzugsweise von mindestens 70 K. Sie sind schwarz und ihre Hauptphasen kristallisieren im orthorhombischen System.

In den Substanzen ist der Sauerstoffgehalt etwas höher als für zweiwertiges Kupfer und dreiwertiges Wismut errechnet. Daher enthalten sie wahrscheinlich auch $Cu^{+++}$-Ionen oder $Bi^{4+}/Bi^{5+}$-Ionen. Bei vorgegebenen Verhältnissen Bi:Erdalkali:Cu ist ein möglichst hoher Sauerstoffgehalt für die Supraleitfähigkeit vorteilhaft.

Eine Ausführungsform der Erfindung betrifft eine schwarze Kristallmasse mit der Bruttozusammensetzung $Bi_2(Sr,Ca)_yCu_{3-y-k}O_f$, wobei k eine Zahl zwischen -0,05 und + 0,05 und y eine Zahl zwischen 1 bis 2,5, vorzugsweise 1,33 bis 2,25 und f 6 + k bedeutet, wobei das Atomverhältnis Bi:Cu 1:2 bis 2:1 und das Atomverhältnis (Sr + Ca):Cu 1:1 bis 2:1 ist, mit einem Atomverhältnis Sr/Ca von 1:9 bis 9:1, einer Sprungtemperatur $T_c$ für die Supraleitfähigkeit von mindestens 60 K und einer Hauptphase, die im orthorhombischen System kristallisiert. In diesen Kristallmassen beträgt das Atomverhältnis (Ca + Sr + Cu):Bi etwa 1,5. Dabei ist k vorzugsweise null und y insbesondere 1,33 bis 2,1. Besonders bevorzugt ist der Bereich y = 1,9 - 2,1.

Eine andere Ausführungsform der Erfindung betrifft eine schwarze Kristallmasse mit der Bruttozusammensetzung $Bi_a(Sr,Ca)_bCu_6O_x$ wobei a = 9,8 - 14 und b = 9,8 - 14, mit einem Atomverhältnis Sr/Ca von 1:9 bis 9:1, einem Atomverhältnis Bi:(Sr + Ca) von 0,89 - 1,13, einer Sprungtemperatur $T_c$ für die Supraleitfähigkeit von mindestens 60 K und einer Hauptphase, die im orthorhombischen System kristallisiert.

Der Index für den Sauerstoffanteil beträgt etwa x = 1,5 a + b + 6 . Er hängt etwas von den Temperaturbedingungen ab. Bei hohen Temperaturen der thermischen Nachbehandlung ist x kleiner ist als bei tiefen. Wahrscheinlich kann Sauerstoff reversibel an bestimmten Gitterplätzen aufgenommen werden.

Die erwähnte schwarze Kristallmasse der Bruttozusammensetzung $Bi_a(Sr,Ca)_bCu_6O_x$ mit a = 9,8 bis 14 und b = 9.8 bis 14 und dem Atomverhältnis Bi:(Sr,Ca) = 0,89 bis 1,13 enthält als Hauptbestandteil die supraleitende schwarze, im orthorhombischen System kristallisierende Verbindung der Bruttozusammensetzung $Bi_4(Sr,Ca)_4Cu_2O$ etwa 12 - 14 mit einem Atomverhältnis Sr:Ca von 9:1 bis 1:9 und einer Sprungtemperatur $T_c$ für die Supraleitfähigkeit von mindestens 60 K. Auch in diesen Massen beträgt das Atomverhältnis Ca:Sr insbesondere 3:1 - 1:3.

Die neuen Substanzen lassen sich dadurch herstellen, daß man Oxide oder Oxidvorläufer der Elemente Bi, Sr, Ca und Cu gründlich vermischt und das Gemisch auf Temperaturen von mindestens 700 °C erhitzt.

Während der Reaktion ändert sich das Atomverhältnis der eingesetzten Metalle in erster Näherung nicht. Das verwendete Atomverhältnis entspricht daher der angestrebten Oxidzusammensetzung.

Als Oxidvorläufer lassen sich allgemein Verbindungen, die bei der Reaktionstemperatur zu den entsprechenden Oxiden reagieren, einsetzen, insbesondere die Hydroxide und Nitrate. Verwendbar sind ferner die Acetate, Formiate, Oxalate sowie Carbonate der genannten Metalle. Verwendbar sind z.B. Calciumoxid, Strontiumcarbonat, Wismutsäure,

2

Wismut-III-oxid, Wismut-V-oxid, $Cu_2O$ und CuO.

Das Reaktionsgemisch braucht nicht oder nur teilweise zu schmelzen. In diesem Fall ist es jedoch erforderlich, längere Zeit bei der Reaktionstemperatur zu halten.

Die Synthesetemperatur liegt in diesem Fall vorzugsweise im Bereich zwischen 700 und 900 °C, vorzugsweise 750 - 850 °C.

Die Reaktionszeit soll mindestens 4 Stunden, noch besser mindestens 8 Stunden betragen. Nach oben wird die Reaktionszeit nur durch wirtschaftliche Überlegungen begrenzt. Reaktionszeiten von 100 bis 120 Stunden sind möglich.

Man kann auch das Gemisch so hoch erhitzen, daß es vollständig geschmolzen ist. Die Erfindung betrifft daher auch ein Verfahren zur Herstellung von Wismut, Strontium, Calcium und Kupfer enthaltenden supraleitenden Massen oder Verbindungen, das dadurch gekennzeichnet ist, daß man ein Gemisch der Oxide von Wismut, Calcium, Strontium und Kupfer oder entsprechender Oxidvorläufer mit Atomverhältnissen Bi:Cu von 1:2 bis 2:1, (Sr + Ca):Cu vom 1:1 bis 2:1, Sr/Ca von 1:9 bis 9:1 und Bi(Sr + Ca) von 0,3:1 bis 1,3:1 herstellt, das Gemisch so hoch erhitzt, daß alle Komponenten geschmolzen sind, man auf Temperaturen von 300 - 900 °C abkühlt, mindestens eine Stunde in diesem Temperaturbereich hält und dann weiter abkühlt. In diesem Fall kann rasch auf Temperaturen unterhalb des Erstarrungspunktes der gesamten Masse; d.h. 300 - 900 °C, vorzugsweise 300 - 830 °C, abgekühlt und längere Zeit (mindestens eine Stunde, vorzugsweise 4 Stunden) in diesem Bereich gehalten werden.

Eine bevorzugte Ausgestaltung des Schmelzverfahrens ist dadurch gekennzeichnet, daß man die Schmelze der Komponenten auf ein Substrat aufträgt, erstarren läßt und die erstarrte Schmelze bei Temperaturen von 300 bis 900 °C, vorzugsweise 300 - 830 °C erhitzt. Insbesondere kann man die Schmelze in dünnen Schichten, vorzugsweise Schichten von 1 μm - 5mm auftragen. Nach der anschließenden Temperaturbehandlung erhält man so kompakte Schichten des Supraleiters auf eine Unterlage. Das Substrat (Unterlage) soll nicht mit dem Reaktionsgemisch reagieren. Geeignet sind z.B. $Al_2O_3$, $SiO_2$ - (Quarz), $ZrO_2$, Strontiumtitanat und Bariumtitanat, sowie Metalle wie Stahl und Cr-Ni-Legierungen als Material für das Substrat.

Eine weitere Ausgestaltung des erfindungsgemäßen Verfahrens zeichnet sich dadurch aus, daß man die Schmelze zu Fäden spinnt, die Fäden erstarren läßt und bei Temperaturen von 300 - 900 °C, vorzugsweise 300 - 830 °C erhitzt. Die getemperten Fäden oder Drähte sind ebenfalls supraleitend.

Die eigentliche Reaktion soll in einer nicht-reduzierenden Atmosphäre stattfinden. Verwendbar sind z.B. Luft, reiner Sauerstoff, Gemische von $O_2$/Ar oder $O_2$/$N_2$. Es ist bevorzugt, wenn die Umsetzung oder Oxide in einer Sauerstoff enthaltenden Atmosphäre durchgeführt wird.

Nach beendeter Reaktion wird die Probe entweder aus dem Ofen entnommen und in Luft oder Sauerstoff oder im Ofen langsam auf Raumtemperatur abgekühlt. Niedrige (maximal 100 K/h) Abkühlungsgeschwindigkeiten wirken sich günstig auf die supraleitenden Eigenschaften des Reaktionsprodukts aus.

Um sicherzustellen, daß sich das gesamte Oxidgemisch umgesetzt hat, ist es vorteilhaft, das getemperte Metalloxid nach dem Abkühlen weiter zu zerkleinern, zu vermischen und in einem Temperaturbereich von 300 bis 900 °C erneut für mindestens eine Stunde zu erhitzen. Die Dauer der Nachbehandlung beträgt vorzugsweise mindestens 4 Stunden. Für die Obergrenze der Nachbehandlungszeit gilt das für die Reaktionsdauer gesagte.

Bevorzugte Untergrenzen der Temperatur bei Nachbehandlung liegen bei mindestens 300 °C, insbesondere 400 °C, eine bevorzugte Obergrenze bei 750 °C, besser 600 °C, insbesondere 550 °C, noch besser 500 °C. Die mögliche Nachreaktion soll in Luft, reinem Sauerstoff, oder einem Gasgemisch wie $O_2$/Ar oder $O_2$/$N_2$ durchgeführt werden. Als Reaktionsgefäße können handelsübliche Tiegel oder Schiffchen aus inerten Materialien, wie z.B. Aluminiumoxid, Zirkon, Platin oder Iridium benutzt werden. Als Wärmequelle eignen sich handelsübliche Öfen, wie z.B. Kammer-, Muffel- oder Rohröfen.

Eine weitere Ausgestaltung des erfindungsgemäßen Verfahren zur Herstellung der supraleitenden Substanzen besteht darin, daß man Salze von Wismut, Calcium, Strontium und Kupfer, von denen mindestens eines wasserlöslich ist in Gegenwart einer wäßrigen Phase vermischt, Gemisch eindampft und erhitzt. Hinsichtlich der Reaktionszeit gilt das gleiche wie bei Verwendung der Oxide.

Das einzudampfende Salzgemisch läßt sich auch dadurch herstellen, daß man die Metalloxide in Salpetersäure löst und die Salpetersäure abraucht.

Man kann auch, soweit wasserlösliche Salze eingesetzt werden, durch Zugabe einer Base, z.B. Tetramethylammonium-Hydroxid, die Metallhydroxide oder zumindest ein Metallhydroxid ausfällen. Auf diese Weise gelingt es, ein besonders gründliches Vermischen der Ausgangsprodukte zu erzielen. Die ausgefällten Hydroxide bilden mit dem nicht in Lösung gegangenen Anteil den "unlöslichen Anteil". Dieser kann abgetrennt, getrocknet und dann wie oben angegeben getempert werden. Vorzugsweise werden durch die verwendete Base keine schwer flüchtigen Kationen eingeschleppt und leiten sich die eingesetzten Salze von leicht flüchtigen Säuren ab. Das sind Säuren deren Siedepunkt unter 150 °C liegt.

Auch bei dieser Ausgestaltung des erfindungsgemäßen Verfahrens entspricht das Atomverhältnis der eingesetzten Metallsalze dem angestrebten Atomverhältnis des Endproduktes. Die aus den Salzen hergestellten oxidischen Produkte lassen sich, wie oben beschrieben, ebenfalls thermisch nachbehandeln.

Aus der erfindungsgemäßen schwarzen Kristallmasse lassen sich bei kupferreichen Ansätzen nach Aufschmelzen, Abkühlen und Zermahlen unter dem Mikroskop Kristalle von $Cu_2O$ (rot) und CuO (Nadeln) entfernen. Es verbleibt eine schwarze Kristallmasse.

Falls bei der Herstellung ein Atomverhältnis Bi:(Sr + Ca):Cu von 2:2:1 eingehalten wird, lassen sich reine schwarze Kristalle der Zusammensetzung $Bi_4(Sr,Ca)_4Cu_2O_x$ erhalten, deren Sprungtemperatur $T_c$ für die Supraleitfähigkeit mindestens 60 K, meist 70 - 85 K, beträgt. Bevorzugt sind dabei Atomverhältnisse Ca:Sr von 3:1 bis 1:3, insbesondere 1,4:3 - 1,8:3 und besonders bevorzugt von etwa 1,6:3. Der Index für den Sauerstoffgehalt (x) liegt in supraleitenden Kristallen etwa zwischen 12 und 14.

Wenn man die Atomverhältnisse des Ansatzes geringfügig ändert, wird eine Verbindung mit gleichen Gitterkonstanten und etwas abweichender Zusammensetzung erhalten. Verwendbar sind insbesondere Ansätze mit Atomverhältnissen Cu:Bi von 1:1,9 - 1:2,1, (Ca + Sr):Cu von 1,9:1 - 2,1:1, (Ca + Sr):Bi von 0,9:1 - 1,1:1 und Ca:Sr von 9:1 - 1:9, insbesondere 3:1 - 1:3; vorzugsweise 1:1 - 1:3.

Diese Verbindung läßt sich nach dem allgemein angegebenen Verfahren herstellen.

Demgegenüber weisen die aus M.A. Subramanian et al., Science, Vol. 239, 1015 vom 28.2.88 bekanntgewordenen Supraleiter ein anderes Atom Verhältnis Wismut:Erdalkali:Kupfer auf und die C-Achse der orthorhombischen Sub-Zelle beträgt nur $30,9 \cdot 10^{-8}$ cm.

Mit dem erfindungsgemäßen Verfahren lassen sich aus Laborchemikalien mit einer Reinheit von nur etwa 99,5 % supraleitende Substanzen gewinnen.

Wenn man die Atomverhältnisse des Ansatzes für die Verbindung $Bi_4(Ca,Sr)_8Cu_6O_{\approx 20}$ geringfügig ändert, wird eine Masse erhalten, die einen sehr hohen Anteil der Verbindung mit dem angegebenen Schichtaufbau und den angegebenen Gitterkonstanten aber etwas abweichender Zusammensetzung aufweist. Verwendbar sind z.B. Ansätze mit Atomverhältnissen Cu:Bi von 3:1,9 - 3:2,1, (Ca + Sr):Cu von 8:5,8 - 8:6,2, (Ca + Sr):Bi von 2,1 - 1,9:1 und Ca:Sr von 1:1 - 1:5, insbesondere 1:1,9 - 1:2,1.

Die gewonnenen supraleitenden Substanzen lassen sich in der Energietechnik (für Kabel und Drähte, Transformatoren, und Energiespeicher in Form stromdurchflossener Spulen), in der Magnettechnologie (z.B. für Kernspintomographen und zur Herstellung von Haltemagneten für Schwebebahnen), in der Computertechnik (dünne Schichten, Verbindungen auf Leiterplatten, Josephson-Schaltelemente) und für elektronische Bauelemente (Detektoren, Antennen, Transistoren, elektronische Sensoren, z.B. SQUID's, Galvanomter, Modulatoren, Bolometer und SLUGs) verwenden. Die Anwendung der Supraleitung in der Meßtechnik wird behandelt in dem gleichnamigen Aufsatz von Prof. F. Baumann, Karlsruhe, in einer Aufsatzreihe des VDI-Bildungswerks (1976).

Es wurde ferner gefunden, das mehrere Maßnahmen vorteilhaft sind, um den Anteil einer Phase mit $T_c \approx 110$ K zu erhöhen.

Die Erfindung betrifft daher auch ein Verfahren zur Herstellung von Wismut, Strontium, Calcium und Kupfer enthaltenden supraleitenden Massen oder Verbindungen, bei dem man ein Gemisch der Oxide von Wismut, Calcium, Strontium und Kupfer oder entsprechender Oxidvorläufer bereitet, dessen Zusammensetzung im Dreieckskoordinatensystem zwischen den ein Parallelogramm definierenden Punkten ABCD liegt, wobei A = $Bi_{0,19}E_{0,35}Cu_{0,46}$, B = $Bi_{0,14}E_{0,4}Cu_{0,46}$, C = $Bi_{0,3}E_{0,38}Cu_{0,32}$, D = $Bi_{0,25}E_{0,43}Cu_{0,32}$ und E die Summe der Erdalkalien Ca + Sr bedeutet, und das Atomverhältnis Ca/Sr 0,85:1 - 1,2:1, insbesondere 0,95:1 - 1,1:1 beträgt, man das Ausgangsgemisch der Oxide oder Oxidvorläufer auf Temperaturen von oberhalb 860 °C aber unter unterhalb des Schmelzpunktes in einer Sauerstoff enthaltenden Atmosphäre während mindestens 50 Stunden aufheizt, man danach auf eine Temperatur von 550 - 650 °C, vorzugsweise 580 - 620, insbesondere 590 - 610 °C abkühlt, man für mindestens 20 Minuten bei dieser Temperatur hält und wieder auf die Sintertemperatur aufheizt und man diesen Vorgang mindestens 2 x wiederholt.

Bei der angegebenen Bruttozusammensetzung der Reaktionsmischung im Dreieckskoordinatensystem wurde der Sauerstoff-Anteil vernachlässigt.

Das Atomverhältnis Calcium/Strontium beträgt insbesondere 1:1. Vorzugsweise liegt die Bruttozusammensetzung zwischen den einen Geradenabschnitt definierenden Eckpunkten $Bi_{0,2}E_{0,4}Cu_{0,4}$ und $Bi_{0,25}E_{0,4}Cu_{0,35}$. Bei einem Atomverhältnis Ca/Sr von 1:1 entspricht dies den Eckpunkten $BiSrCaCu_2O_x$ und $BiSr_{0,8}Ca_{0,8}Cu_{1,4}O_x$.

Es ist weiterhin vorteilhaft, den Sintervorgang bei möglichst hohen Temperaturen durchzuführen (ohne daß der Ansatz schmilzt). Die Dauer des Sintervorgangs beträgt vorteilhafterweise mindestens 80 Stunden. Beim Sintern in reinem Stickstoff beginnt der Ansatz etwa 40 K früher zu schmelzen.

Vorteilhafterweise wird das Abkühlen des Ansatzes nach dem Sintern und das erneute Aufheizen auf Sintertemperaturen bis zu 20 mal wiederholt. Danach nimmt der Anteil der supraleitenden Phase wieder ab. Bevorzugt ist es, den Zyklus 2-6 mal, insbesondere 2-3 mal zu wiederholen. Die Zeit für das Abkühlen von Sintertemperatur auf 550 - 650 °C, das Halten im Bereich von 550 - 650 °C und das Wiederaufheizen auf Sintertemperatur sollen jeweils mindestens 30 Minuten dauern, besser sind mindestens 45 Minuten. Bevorzugt ist für die Zeit des Abkühlens auf 550 - 650 °C und das Halten bei 550 - 650 °C eine Zeit von jeweils mindestens einer Stunde, insbesondere 1- 3 Stunden. Eine weitere Erhöhung dieser Zeiten scheint keine Vorteile zu bieten.

Die Erfindung wird durch die Beispiele näher erläutert.

Beispiel 1

1 Mol $Bi_2O_3$, 2 Mol SrO, 2 Mol CaO und 2 Mol CuO werden in einem Achatmörser zerkleinert, innigst vermengt und in ein Schiffchen aus $Al_2O_3$ überführt.

Die Probe wird in einem geeigneten Laborofen schnell auf 950 °C erhitzt, wobei die Probe schmilzt. Direkt von 950°C auf Raumtemperatur abgeschreckte Proben zeigen ein Röntgenbeugungsdiagramm gemäß Tabelle 1, sowie keine Supraleitung.

Wird die Probe von 950°C auf 700°C abgekühlt und bei dieser Temperatur eine Stunde gehalten und anschließend schnell auf Raumtemperatur abgekühlt, so zeigen Bruchstücke des so erhaltenen Schmelzkuchens bei Messungen in einem SQUID-Magnetometer eine kritische Temperatur $T_c$ = 70 K.

Das Röntgenbeugungsdiagramm dieser Probe zeigt das Auftauchen einer weiteren kristallinen Phase (Tabelle 2).

Wird die Probe von 700°C auf 500°C abgekühlt und dort wiederum eine Stunde getempert, so zeigt das Pulverdiagramm die bei 700°C aufgetauchte Phase als Hauptprodukt (Tabelle 3). Diese Probe zeigt ebenfalls eine kritische Temperatur von ca. 70 K. (SQUID-Magnetometer).

**Beispiel 2**

3 Mol $SrCO_3$, 1,5 Mol $Bi_2O_3$, 3 Mol $CaCO_3$ und 6 Mol CuO werden in einem Achatmörser zerkleinert, gründlich gemischt und in einen Tiegel aus $Al_2O_3$ überführt.

Die Probe wird an der Luft in einem geeigneten Laborofen in 6 Stunden auf 800°C erhitzt und dort 6 Stunden gehalten. Anschließend wird die Probe in 2 Stunden auf 400°C abgekühlt, bei dieser Temperatur weitere 3 Stunden gehalten, dann in 2 Stunden auf 100°C abgekühlt und dem Ofen entnommen.

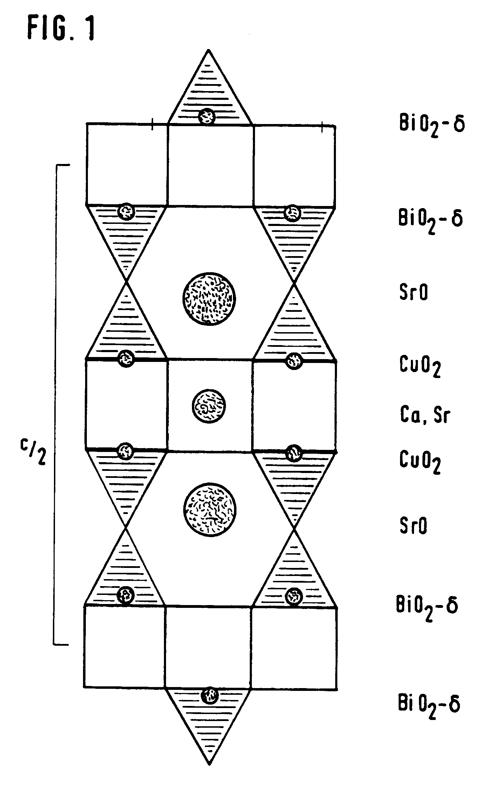

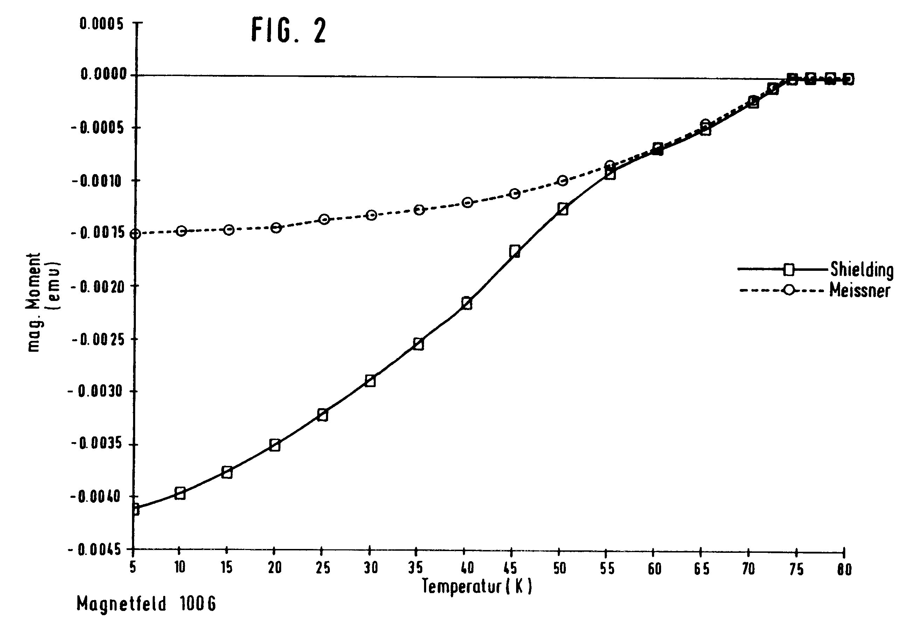

Das so hergestellte schwarze Material zeigte bei Messungen mit einem SQUID-Magnetometer eine Sprungtemperatur $T_c$ = 75 K (Fig. 2).

**Beispiel 3:**

0,2 mol $Bi_2O_3$, 0,6 mol SrO, 0,2 mol CaO und 0,6 mol CuO werden zerkleinert, vermengt und in einem Korundtiegel schnell auf 830°C erhitzt. Man hält 2 Stunden bei dieser Temperatur und tempert anschließend an Luft bei 800°C 3 Stunden nach. Man schreckt den Ansatz von 800°C auf Raumtemperatur ab, indem man dem Ofen entnimmt und an Luft abkühlen läßt.

Man erhält eine Verbindung der ungefähren Zusammensetzung $Bi_4(Ca,Sr)_{4+4}Cu_{2+2 \cdot 2} O_{12+4 \cdot 2}$. Das Atomverhältnis Sr/Ca beträgt 4:1. Die Sprungtemperatur $T_c$ beträgt 70-82 K.

**Beispiel 4:**

0,01 mol CaO, 0,01 mol $Bi_2O_3$, 0,01 mol SrO und 0,01 mol CuO werden in einem Achatmörser vermengt, zerkleinert und in ein Korundschiffchen überführt. Der Ansatz wird in einem Laborofen an Luft schnell auf 1000°C erhitzt und bei dieser Temperatur 30 Minuten lang gehalten. Dabei schmilzt die Kristallmasse. Anschließend läßt man im Ofen auf Raumtemperatur abkühlen. Der schwarze stengelartig erstarrte Schmelzkuchen wird im Mörser zerkleinert, nochmals erhitzt (in 2 Stunden in Sauerstoffatmosphäre auf 800°C), dann 3 Stunden bei 800°C gehalten und in 3 Stunden auf Raumtemperatur abgekühlt.

Eine anschließende Messung der Suszeptibilität in einem SQUID-Magnetometer ergibt eine Sprungtemperatur von 77 K. Die Verbindung hat die Bruttozusammensetzung $Bi_4(Ca,Sr)_4Cu_2O_{\approx 14}$.

**Beispiel 5:**

0,02 mol CaO, 0,01 mol $Bi_2O_3$, 0,02 mol SrO und 0,04 mol CuO werden in einem Achatmörser vermengt, zerkleinert und in ein Korundschiffchen überführt. Der Ansatz wird in einem Laborofen an Luft in einer Stunde auf 1000°C erhitzt und bei dieser Temperatur 30 Minuten lang gehalten. Dabei bildet sich eine Schmelze. Anschließend kühlt man in 2 Stunden auf 500°C ab und nimmt den Ansatz bei dieser Temperatur aus dem Ofen heraus. Eine anschließende Messung der Suszeptibilität in einem SQUID-Magnetometer ergibt eine Sprungtemperatur von etwa 80 K.

Nach röntgenographischen Untersuchungen ist das Hauptprodukt $Bi_4(Sr,Ca)_6Cu_4O_{\approx 20}$.

**Beispiel 6:**

2 mol $Bi_2O_3$, 4 mol $SrCO_3$, 4 mol CaO und 8 mol CuO werden in einem Achatmörser zerkleinert, gründlich gemischt und in einen Tiegel aus $Al_2O_3$ überführt. Die Probe wird an Luft schnell auf 800 - 820°C erhitzt, dort 20 Stunden gehalten und schnell auf Raumtemperatur abgekühlt. Das geglühte Pulver wird zerkleinert und noch weitere zwei Male wie oben beschrieben thermisch und mechanisch behandelt.

Anschließend wird das schwarze Pulver unter einem Druck von 300 MPa (3 kbar) zu Tabletten gepreßt, diese auf MgO-Platten gelegt und, wie im folgenden beschrieben, unterschiedlich thermisch behandelt (an Luft):

a) Vergleichsbeispiel
Aufheizen in 3 Stunden auf 870°C
80 Stunden Tempern bei 870°C
Abkühlen in 2 min auf Raumtemperatur (=RT) ("Abschrecken") Leitfähigkeitsmessung: $T_c$ (R=O)= 57 K
SQUID-Messung: 12 % supraleitender Anteil bei 4 K (gemessen bei B = 100 Gauß; 1 Gauß = $10^{-4}$ $Wb/m^2$)
b) Vergleichsbeispiel
Aufheizen in 3 Stunden auf 870°C
80 Stunden Tempern bei 870°C
Abkühlen in 3 Stunden auf 600°C
Abschrecken von 600°C auf RT (2 min)
Leitfähigkeit: $T_c$ (R=O)= 63 K
SQUID-Messung: -
c) Aufheizen in 3 Stunden auf 870°C
80 Stunden Tempern bei 870°C
Abkühlen in 3 Stunden auf 600°C
3 Stunden Tempern bei 600°C
Aufheizen in 3 Stunden auf 870°C
3 Stunden Tempern bei 870°C
Abkühlen in 3 Stunden auf 600°C
3 Stunden Tempern bei 600°C
Aufheizen in 3 Stunden auf 870°C
3 Stunden Tempern bei 870°C
Abkühlen in 3 Stunden auf 600°C
3 Stunden Tempern bei 600°C
Abkühlen in 3 Stunden auf RT
Leitfähigkeitsmessung: $T_c$ (R=O)= 107 K
SQUID-Messung: 30 % supraleitender Anteil bei 4 K (gemessen bei 100 Gauß)
d) Aufheizen in 3 Stunden auf 864°C
50 Stunden Tempern bei 864°C
sechsmal folgenden Temperaturcyclus durchlaufen:
Abkühlen in 1 Stunde auf 600°C
1 Stunde Tempern bei 600°C
Aufheizen in 1 Stunde auf 864°C
1 Stunde Tempern bei 864°C
anschließend:
Abkühlen in 3 Stunden auf 600°C
3 Stunden Tempern bei 600°C
Abkühlen in 3 Stunden auf RT
Leitfähigkeitsmessung: $T_c$ (R=O)= 102 K
SQUID-Messung: 25 % supraleitender Anteil bei 4 K (gemessen bei B = 100 Gauß)
e) Aufheizen in 3 Stunden auf 870°C
80 Stunden Tempern bei 870°C
zwölfmal folgenden Temperaturcyclus durchlaufen:
Abkühlen in 3 Stunden auf 600°C
3 Stunden Tempern bei 600°C
Aufheizen in 3 Stunden auf 870°C
3 Stunden Tempern bei 870°C
anschließend:
Abkühlen in 3 Stunden auf 600°C

3 Stunden Tempern bei 600°C
Abkühlen in 3 Stunden auf RT
Leitfähigkeit: $T_c$ (R=O)= 105 K
SQUID-Messung: 26 % supraleitender Anteil bei 4 K (gemessen bei B = 100 Gauß)
f) Aufheizen in 3 Stunden auf 870°C 80 Stunden Tempern bei 870°C
dreimal folgenden Temperaturcyclus durchlaufen:
Abkühlen in 3 Stunden auf 600°C
3 Stunden Tempern bei 600°C
Aufheizen in 3 Stunden auf 870°C
3 Stunden Tempern bei 870°C
anschließend:
Abkühlen in 3 Stunden auf 600°C
3 Stunden Tempern bei 600°C
Abkühlen in 3 Stunden auf RT
Leitfähigkeit: $T_c$ (R=O)= 98 K
SQUID-Messung: 35 % supraleitender Anteil bei 4 K mit 100 Gauß gemessen
50 % Supraleitender Anteil mit 10 Gauß gemessen 1 Gauß = $10^{-4}$ Wb/m$^2$

**Beispiel 7** (Vergleichsbeispiel)

4,3 mol $Bi_2O_3$, 7 mol $SrCO_3$, 7 mol CaO und 12 mol CuO werden in einem Achatmörser zerkleinert, gemischt und in einen $Al_2O_3$-Tiegel überführt. Die Probe wird an Luft schnell auf 800 - 820°C erhitzt, dort 20 Stunden gehalten, schnell auf RT abgekühlt und zerkleinert (Achatmörser). Das Tempern + Zerkleinern wird noch zweimal wiederholt. Anschließend wird das Pulver unter einem Druck von 300 MPa (3 Kbar) zu Tabletten gepreßt und, wie im folgenden beschrieben, auf MgO-Platten thermisch behandelt:

a) Aufheizen in 3 Stunden auf 866°C
65 Stunden Tempern bei 866°C
sechsmal folgenden Temperaturcyclus durchlaufen:
Abkühlen in 3 Stunden auf 600°C
3 Stunden Tempern bei 600°C
Aufheizen in 3 Stunden auf 866°C
3 Stunden Tempern bei 866°C
anschließend:
3 Stunden Abkühlen auf 600°C
3 Stunden Tempern bei 600°C
Abkühlen in 3 Stunden auf RT $T_c$ (R=O)= 66 K
b) Aufheizen in 3 Stunden auf 866°C
53 Stunden Tempern bei 866°C
sechsmal folgenden Temperaturcyclus durchlaufen:
Abkühlen in 3 Stunden auf 600°C
3 Stunden Tempern bei 600°C
Aufheizen in 3 Stunden auf 866°C
3 Stunden Tempern bei 866°C
anschließend:
3 Stunden Abkühlen auf 600°C
3 Stunden Tempern bei 600°C
Abkühlen in 3 Stunden auf RT $T_c$ (R=O)= 95 K
24 % supraleitender Anteil bei 4 K (gemessen mit B = 100 Gauß)
c) Aufheizen in 3 Stunden auf 868°C
34 Stunden Tempern bei 868°C
neunmal folgenden Temperaturcyclus durchlaufen:
Abkühlen in 3 Stunden auf 600°C
3 Stunden Tempern bei 600°C
Aufheizen in 3 Stunden auf 868°C
3 Stunden Tempern bei 868°C
anschließend:
3 Stunden Abkühlen auf 600°C

3 Stunden Tempern bei 600°C
Abkühlen in 3 Stunden auf RT $T_c$ (R=O)= 60 K

**Beispiel 8** (Vergleichsbeispiel)

2 mol $Bi_2O_3$, 4 mol $SrCO_3$, 4 mol CaO und 12 mol CuO werden nach der in Beispiel 6 angegebenen Methode zu Tabletten verarbeitet. Diese werden unterschiedlich thermisch behandelt (an Luft):

a) Aufheizen 3 Stunden auf 863°C
50 Stunden Tempern bei 863°C
sechsmal folgenden Cyclus durchlaufen:
Abkühlen in 1 Stunde auf 600°C
1 Stunde Tempern bei 600°C
Aufheizen in 1 Stunde auf 863°C
1 Stunde Tempern bei 863°C
anschließend:
Abkühlen in 1 Stunde auf 600°C
1 Stunde Tempern bei 600°C
Abkühlen in 1 Stunde auf RT $T_c$ (R=O) = 66 K
b) Aufheizen in 3 Stunden auf 868°C
34 Stunden Tempern bei 860°C
achtmal folgenden Cyclus durchlaufen:
Abkühlen in 1 Stunde auf 600°C
1 Stunde Tempern bei 600°C
Aufheizen in 1 Stunde auf 868°C
1 Stunde Tempern bei 868°C
dann:
Abkühlen in 1 Stunde auf 600°C
1 Stunde Tempern bei 600°C
Abkühlen in 1 Stunde auf RT $T_c$ (R=O) = 64 K

**Beispiel 9** (Vergleichsbeispiel)

1 mol $Bi_2O_3$, 2 mol $SrCO_3$, 2 mol CaO und 3 Mol CuO werden nach der in Beispiel 6 angegebenen Methode zu Tabletten verarbeitet. Diese werden an Luft wie folgt thermisch behandelt:

Aufheizen in 3 Stunden auf 870°C
80 Stunden Tempern bei 870°C
zweimal folgenden Cyclus durchlaufen:
Abkühlen in 3 Stunden auf 600°C
3 Stunden Tempern bei 600°C
Aufheizen in 3 Stunden auf 870°C
3 Stunden Tempern bei 870°C
dann:
Abkühlen in 3 Stunden auf 600°C
3 Stunden Tempern bei 600°C
Abkühlen in 3 Stunden auf RT $T_c$ (R=O) = 65 K
20 % supraleitender Anteil bei 4 K (gemessen bei 100 Gauß)

Tabelle 1

| NO | 2 THETA | D | INTEG.I (%) |
|----|---------|-------|-------------|
| 1 | 7.125 | 12.4060 | 6.6 |
| 2 | 16.709 | 5.3057 | 0.5 |
| 3 | 21.674 | 4.1002 | 27.7 |
| 4 | 23.487 | 3.7877 | 0.7 |
| 5 | 25.718 | 3.4640 | 20.7 |
| 6 | 29.222 | 3.0560 | 100.0 |
| 7 | 29.600 | 3.0179 | 26.9 |
| 8 | 30.455 | 2.9351 | 3.9 |
| 9 | 31.937 | 2.8022 | 5.2 |
| 10 | 33.154 | 2.7021 | 14.8 |
| 11 | 34.884 | 2.5719 | 7.3 |
| 12 | 35.620 | 2.5204 | 0.6 |
| 13 | 36.532 | 2.4596 | 8.5 |
| 14 | 37.193 | 2.4173 | 6.2 |
| 15 | 37.854 | 2.3767 | 1.0 |
| 16 | 40.085 | 2.2494 | 1.1 |
| 17 | 41.047 | 2.1989 | 0.6 |
| 18 | 41.962 | 2.1530 | 15.4 |
| 19 | 44.368 | 2.0417 | 2.7 |
| 20 | 44.706 | 2.0270 | 8.9 |
| 21 | 50.234 | 1.8162 | 0.9 |
| 22 | 52.027 | 1.7577 | 16.8 |
| 23 | 53.693 | 1.7070 | 2.2 |
| 24 | 54.214 | 1.6919 | 1.3 |
| 25 | 54.972 | 1.6703 | 1.3 |
| 26 | 57.077 | 1.6136 | 9.0 |

Tabelle 2

| NO | 2 THETA | D | INTEG.I (%) | | | |
|----|---------|---|-------------|---|---|---|
| 1 | 4.122 | 21.4351 | 3.6 | | | |
| 2 | 4.302 | 20.5386 | 2.3 | | | |
| 3 | 5.698 | 15.5105 | 1.6 | | | |
| 4 | 7.107 | 12.4381 | 4.3 | | | |
| 5 | 7.682 | 11.5074 | 1.6 | | | |
| 6 | 21.611 | 4.1121 | 29.5 | | | |
| 7 | 22.809 | 3.8986 | 21.9 | | | |
| 8 | 24.713 | 3.6025 | 8.3 | | | |
| 9 | 25.713 | 3.4646 | 26.0 | | | |
| 10 | 26.101 | 3.4140 | 1.5 | | | |
| 11 | 27.278 | 3.2693 | 35.6 | | | |
| 12 | 28.947 | 3.0844 | 100.0 | | | |
| 13 | 29.637 | 3.0142 | 47.5 | | | |
| 14 | 30.149 | 2.9642 | 2.1 | | | |
| 15 | 30.676 | 2.9144 | 45.5 | | | |
| 16 | 31.950 | 2.8011 | 17.4 | | | |
| 17 | 33.057 | 2.7098 | 84.9 | | | |
| 18 | 34.875 | 2.5728 | 38.7 | | | |
| 19 | 35.781 | 2.5094 | 1.3 | | | |
| 20 | 36.497 | 2.4618 | 9.8 | | | |
| 21 | 37.210 | 2.4183 | 12.8 | | | |
| 22 | 39.964 | 2.2559 | 1.8 | | | |
| 23 | 42.093 | 2.1466 | 3.9 | | | |
| 24 | 44.719 | 2.0265 | 99.4 | | | |
| 25 | 46.642 | 1.9473 | 3.8 | | | |
| 26 | 47.382 | 1.9186 | 31.6 | | | |
| 27 | 50.234 | 1.8162 | 14.1 | | | |
| 28 | 52.881 | 1.7313 | 1.5 | | | |
| 29 | 53.697 | 1.7069 | 4.7 | | | |
| 30 | 54.224 | 1.6916 | 2.4 | | | |
| 31 | 54.917 | 1.6719 | 3.6 | | | |
| 32 | 56.343 | 1.6329 | 1.9 | | | |
| 33 | 56.797 | 1.6209 | 3.6 | | | |
| 34 | 57.524 | 1.6021 | 0.9 | 35 | 58.423 | 1.5796 1.6 |

Tabelle 3

| NO | 2 THETA | D-space | INTEG.I (%) |
|----|---------|---------|-------------|
| 1 | 7.231 | 12.21443 | 6.1 |
| 2 | 14.363 | 6.16182 | 8.2 |
| 3 | 16.783 | 5.27810 | 8.3 |
| 4 | 19.324 | 4.58947 | 14.1 |
| 5 | 21.703 | 4.09147 | 8.5 |
| 6 | 23.570 | 3.77145 | 6.4 |
| 7 | 24.696 | 3.60198 | 6.1 |
| 8 | 25.753 | 3.45652 | 61.2 |
| 9 | 27.327 | 3.26082 | 6.2 |
| 10 | 28.700 | 3.10796 | 10.3 |
| 11 | 29.002 | 3.07624 | 48.6 |
| 12 | 29.675 | 3.00800 | 100.0 |
| 13 | 30.202 | 2.95671 | 9.6 |
| 14 | 30.553 | 2.92351 | 8.6 |
| 15 | 31.856 | 2.80687 | 13.6 |
| 16 | 32.057 | 2.78974 | 6.2 |
| 17 | 32.674 | 2.73843 | 6.3 |
| 18 | 32.917 | 2.71878 | 25.6 |
| 19 | 33.216 | 2.69494 | 53.0 |
| 20 | 34.491 | 2.59820 | 9.7 |
| 21 | 34.737 | 2.58039 | 8.7 |
| 22 | 35.681 | 2.51426 | 8.3 |
| 23 | 35.990 | 2.49334 | 7.9 |
| 24 | 36.376 | 2.46778 | 10.6 |
| 25 | 37.231 | 2.41303 | 7.2 |
| 26 | 42.002 | 2.14932 | 13.2 |
| 27 | 44.645 | 2.02803 | 14.2 |
| 28 | 47.340 | 1.91868 | 9.7 |
| 29 | 47.662 | 1.90646 | 19.7 |
| 30 | 51.393 | 1.77645 | 7.2 |
| 31 | 51.789 | 1.76380 | 12.6 |
| 32 | 52.047 | 1.75566 | 7.2 |
| 33 | 53.148 | 1.72185 | 6.8 |
| 34 | 54.943 | 1.66978 | 8.5 |
| 35 | 56.669 | 1.62296 | 6.3 |
| 36 | 56.861 | 1.61791 | 6.5 |
| 37 | 57.072 | 1.61243 | 10.5 |
| 38 | 57.408 | 1.60379 | 6.0 |
| 39 | 57.713 | 1.59604 | 6.6 |
| 40 | 60.004 | 1.54048 | 8.8 |

**Patentansprüche**

**Patentansprüche für folgende Vertragsstaaten : AT, BE, CH, DE, FR, GB, IT, LI, LU, NL, SE**

1. Schwarze Kristallmasse mit der Bruttozusammensetzung $Bi_2(Sr,Ca)_yCu_{3-y-k}O_f$, wobei k eine Zahl zwischen -0,05 und + 0,05 und y eine Zahl zwischen 1 bis 2,5, vorzugsweise 1,33 bis 2,25 und f 6 + k bedeutet, wobei das Atomverhältnis Bi :Cu 1:2 bis 2:1 und das Atomverhältnis (Sr+Ca) : Cu 1:1 bis 2:1 ist, mit einem Atomverhältnis Sr/Ca von 1:9 bis 9:1, einer Sprungtemperatur $T_c$ für die Supraleitfähigkeit von mindestens 60 K und einer Hauptphase, die im orthorhombischen System kristallisiert.

2.  Kristallmasse gemäß Anspruch 1, wobei y eine Zahl zwischen 1,333 und 2,1, insbesondere 1,9 bis 2,1, bedeutet.

3.  Kristallmasse nach Anspruch 1, dadurch gekennzeichnet, daß k = 0 ist.

4.  Schwarze Kristallmasse mit der Bruttozusammensetzung
    $Bi_a(Sr,Ca)_bCu_6O_x$ wobei

    a = 9,8 - 14 und
    b = 9,8 - 14,

    mit einem Atomverhältnis Sr/Ca 1:9 bis 9:1, einem Atomverhältnis Bi: (Sr + Ca) von 0,89 - 1,13, einer Sprungtemperatur $T_c$ für die Supraleitfähigkeit von mindestens 60 K und einer Hauptphase, die im orthorhombischen System kristallisiert.

5.  Schwarze, im orthorhombischen System kristallisierende Verbindung der Bruttozusammensetzung
    $Bi_4(Sr,Ca)_4Cu_2O_{12}$
    mit einem Atomverhältnis Sr:Ca von 9:1 bis 1:9 und einer Sprungtemperatur $T_c$ für die Supraleitfähigkeit von mindestens 60 K.

6.  Verbindung gemäß Anspruch 5, dadurch gekennzeichnet, daß das Atomverhältnis Sr:Ca 1:3 bis 3:1 ist.

7.  Verfahren zur Herstellung von Wismut, Strontium, Calcium und Kupfer enthaltenden supraleitenden Massen oder Verbindungen, dadurch gekennzeichnet, daß man ein Gemisch der Oxide von Wismut, Calcium, Strontium und Kupfer oder entsprechender Oxidvorläufer mit Atomverhältnissen Bi:Cu von 1:2 bis 2:1, (Sr + Ca):Cu von 1:1 bis 2:1, Sr/Ca von 1:9 bis 9:1 und Bi:(Sr + Ca) von 0,3:1 bis 1,3:1 herstellt, das Gemisch so hoch erhitzt, daß alle Komponenten geschmolzen sind, man auf Temperaturen von 300 - 900 °C abkühlt, mindestens eine Stunde in diesem Temperaturbereich hält und dann weiter abkühlt.

8.  Verfahren gemäß Anspruch 7, wobei man Salze von Wismut, Calcium, Strontium und Kupfer, von denen mindestens eines wasserlöslich ist, in Gegenwart einer wäßrigen Phase vermischt, das Gemisch eindampft und erhitzt.

9.  Verfahren nach Anspruch 7, dadurch gekennzeichnet, daß man das isolierte getemperte Metalloxid zerkleinert, vermischt und in einem Temperaturbereich von 300 bis 900 °C erneut für mindestens 1 Stunde Zeit erhitzt.

10. Verfahren nach Anspruch 7, dadurch gekennzeichnet, daß man die Schmelze der Komponenten auf ein Substrat aufträgt, erstarren läßt und die erstarrte Schmelze bei Temperaturen von 300 bis 900 °C, vorzugsweise 300 - 830 °C erhitzt.

11. Verfahren nach Anspruch 10, dadurch gekennzeichnet, daß man die Schmelze in dünnen Schichten, insbesondere Schichten von 1 µm - 5 mm aufträgt.

12. Verfahren nach Anspruch 7, dadurch gekennzeichnet, daß man die Schmelze zu Fäden spinnt, die Fäden erstarren läßt und bei Temperaturen von 300 - 900 °C, vorzugsweise 300 - 830 °C erhitzt.

13. Verfahren nach mindestens einem der Ansprüche 7, 9, 10, 11 und 12, dadurch gekennzeichnet, daß man in einer Atmosphäre erhitzt, die freien Sauerstoff enthält.

14. Verfahren nach mindestens einem der Ansprüche 7, 9, 10, 11, und 12, dadurch gekennzeichnet, daß man in einer Sauerstoff enthaltenden Atmosphäre abkühlt.

15. Verfahren zur Herstellung von Wismut, Strontium, Calcium und Kupfer enthaltenden supraleitenden Massen oder Verbindungen, dadurch gekennzeichnet, daß man ein Gemisch der Oxide von Wismut, Calcium, Strontium und Kupfer oder entsprechender Oxidvorläufer bereitet, dessen Zusammensetzung im Dreieckskoordinatensystem zwischen den ein Parallelogramm definierenden Punkten ABCD liegt, wobei
    A = $Bi_{0.19}E_{0.35}Cu_{0.46}$, B = $Bi_{0.14}E_{0.4}Cu_{0.46}$, C = $Bi_{0.3}E_{0.38}Cu_{0.32}$, D = $Bi_{0.25}E_{0.43}Cu_{0.32}$ und E die Summe der Erdalkalien Ca + Sr bedeutet, und das Atomverhältnis Ca/Sr 0,85:1 - 1,2:1, insbesondere 0,95 : 1 - 1,1:1, beträgt, man das Ausgangsgemisch der Oxide oder Oxidvorläufer auf Temperaturen von oberhalb 860 °C aber unterhalb des Schmelzpunktes in einer Sauerstoff enthaltenden Atmosphäre während mindestens 50 Stunden aufheizt, man danach auf eine Temperatur von 550 - 650 °C, vorzugsweise 580 - 620, insbesondere 590 - 610 °C abkühlt, man für mindestens 20 Minuten bei dieser Temperatur hält und wieder auf die Sintertemperatur aufheizt und man diesen Vorgang mindestens 2 x wiederholt.

16. Verfahren nach Anspruch 15, dadurch gekennzeichnet, daß man Abkühlen und Wiederaufheizen 2 - 20 mal wiederholt.

17. Verfahren nach Anspruch 15, dadurch gekennzeichnet, daß die Zeit für das Abkühlen auf 550 - 650 °C, das Halten im Bereich von 550 - 650 °C und das Wiederaufheizen auf Sintertemperaturen jeweils mindestens 30 Minuten, vorzugsweise mindestens 45 Minuten dauern.

18. Verfahren nach Anspruch 17, dadurch gekennzeichnet, daß die Zeit für das Abkühlen und das Halten bei einer Temperatur von 550 - 650 °C mindestens jeweils eine Stunde dauert.

**Patentansprüche für folgende Vertragsstaaten : ES, GR**

1. Verfahren zur Herstellung von Wismut, Strontium, Calcium und Kupfer enthaltenden supraleitenden Massen oder Verbindungen, dadurch gekennzeichnet, daß man bin Gemisch der Oxide von Wismut, Calcium, Strontium und Kupfer oder entsprechender Oxidvorläufer mit Atomverhältnisse Bi:Cu von 1:2 bis 2:1, (Sr + Ca):Cu vom 1:1 bis 2:1, Sr/Ca von 1:9 bis 9:1 und Bi:(Sr + Ca) von 0,3 bis 1,3:1 herstellt, das Gemisch so hoch erhitzt, daß alle Komponenten geschmolzen sind, man auf Temperaturen von 300 - 900 °C abkühlt, mindestens eine Stunde in diesem Temperaturbereich hält und dann weiter abkühlt.

2. Verfahren gemäß Anspruch 1, wobei man Salze von Wismut, Calcium, Strontium und Kupfer, von denen mindestens eines wasserlöslich ist, in Gegenwart einer wäßrigen Phase vermischt, das Gemisch eindampft und erhitzt.

3. Verfahren nach Anspruch 2, dadurch gekennzeichnet, daß man durch Zugabe einer Base zu dem Gemisch der Salze in Gegenwart einer wäßrigen Phase mindestens ein Metallhydroxid ausfällt, den unlöslichen Anteil abtrennt, trocknet und erhitzt.

4. Verfahren nach Anspruch 2, dadurch gekennzeichnet, daß die eingesetzten Salze sich von leicht flüchtigen Säuren ableiten.

5. Verfahren nach Anspruch 1, dadurch gekennzeichnet, daß man das isolierte getemperte Metalloxid zerkleinert, vermischt und in einem Temperaturbereich von 300 bis 900 °C erneut für mindestens 1 Stunde Zeit erhitzt.

6. Verfahren nach Anspruch 1, dadurch gekennzeichnet, daß man die Schmelze der Komponenten auf ein Substrat aufträgt, erstarren läßt und die erstarrte Schmelze bei Temperaturen von 300 bis 900 °C, vorzugsweise 300 - 830 °C erhitzt.

7. Verfahren nach Anspruch 6, dadurch gekennzeichnet, daß man die Schmelze in dünnen Schichten, insbesondere Schichten von 1 μm - 5 mm aufträgt.

8. Verfahren nach Anspruch 1, dadurch gekennzeichnet, daß man die Schmelze zu Fäden spinnt, die Fäden erstarren läßt und bei Temperaturen von 300 - 900 °C, vorzugsweise 300 - 830 °C erhitzt.

9. Verfahren nach mindestens einem der Ansprüche 1, 5 und 8, dadurch gekennzeichnet, daß man in einer Atmosphäre erhitzt, die freien Sauerstoff enthält.

10. Verfahren nach Anspruch 1, dadurch gekennzeichnet, daß man in einer Sauerstoff enthaltenden Atmosphäre abkühlt.

11. Verfahren zur Herstellung von Wismut, Strontium, Calcium und Kupfer enthaltenden supraleitenden Massen oder Verbindungen, dadurch gekennzeichnet, daß man ein Gemisch der Oxide von Wismut, Calcium, Strontium und Kupfer oder entsprechender Oxidvorläufer bereitet, dessen Zusammensetzung im Dreieckskoordinatensystem zwischen den ein Parallelogramm definierenden Punkten ABCD liegt, wobei

A = $Bi_{0.19}E_{0.35}Cu_{0.46}$, B = $Bi_{0.14}E_{0.4}Cu_{0.46}$, C = $Bi_{0.3}E_{0.38}Cu_{0.32}$, D = $Bi_{0.25}E_{0.43}Cu_{0.32}$ und E die Summe der Erdalkalien Ca + Sr bedeutet, und das Atomverhältnis Ca/Sr 0,85:1 - 1,2:1, insbesondere 0,95 : 1 - 1,1:1, beträgt, man das Ausgangsgemisch der Oxide oder Oxidvorläufer auf Temperaturen von oberhalb 860 °C aber unterhalb des Schmelzpunktes in einer Sauerstoff enthaltenden Atmosphäre während mindestens 50 Stunden aufheizt, man danach auf eine Temperatur von 550 - 650 °C, vorzugsweise 580 - 620, insbesondere 590 - 610 °C abkühlt, man für mindestens 20 Minuten bei dieser Temperatur hält und wieder auf die Sintertemperatur aufheizt und man diesen Vorgang mindestens 2 x wiederholt.

**12.** Verfahren nach Anspruch 11, dadurch gekennzeichnet, daß man das Aufheizen in einer sauerstoffhaltigen Atmosphäre während mindestens 80 Stunden vornimmt.

**13.** Verfahren nach Anspruch 11, dadurch gekennzeichnet, daß man Abkühlen und Wiederaufheizen 2 - 20 mal wiederholt.

**14.** Verfahren nach Anspruch 11, dadurch gekennzeichnet, daß die Zeit für das Abkühlen auf 550 - 650 °C, das Halten im Bereich von 550 - 650 °C und das Wiederaufheizen auf Sintertemperaturen jeweils mindestens 30 Minuten, vorzugsweise mindestens 45 Minuten dauern.

**15.** Verfahren nach Anspruch 11, dadurch gekennzeichnet, daß die Zeit für das Abkühlen und das Halten bei einer Temperatur von 550 - 650 °C mindestens jeweils eine Stunde dauert.

**16.** Verfahren nach Anspruch 1, dadurch gekennzeichnet, daß man ein Atomverhältnis Bi:Cu von 2:(3-y + k), ein Atomverhältnis (Sr + Ca);:CU von y:(3-y + k) und ein Atomverhältnis Bi:(Sr + Ca) von 2:y einhält, wobei y eine Zahl zwischen 1 und 2,5 und k eine Zahl zwischen -0,05 und + 0,05 ist.

**17.** Verfahren nach Anspruch 16, dadurch gekennzeichnet, daß k = 0 ist.

**18.** Verfahren zur Herstellung von Wismut, Strontium, Calcium und Kupfer enthaltenden supraleitenden Massen oder Verbindungen, wobei man ein Gemisch der Oxide von Wismut, Calcium, Strontium und Kupfer oder entsprechender Oxidvorläufer bereitet und erhitzt, dadurch gekennzeichnet, daß man ein Atomverhältnis Ca:Sr = 1:9 bis 9:1, ein Atomverhältnisse Bi:Cu = 1,633 - 2,333, ein Atomverhältnis (Sr + Ca):Cu = 1,633 - 2,333 und ein Atomverhältnis Bi:(Sr + Ca) = 0,89 - 1,13 einhält, man das Gemisch auf Temperaturen von mindestens 700°C aufheizt, so daß das Gemisch nicht oder nur teilweise geschmolzen ist, man mindestens 4 Stunden in diesem Temperaturbereich hält und dann abkühlt.

### Claims

### Claims for the following Contracting States : AT, BE, CH, DE, FR, GB, IT, LI, LU, NL, SE

**1.** A black crystalline substance with the overall composition $Bi_2(Sr,Ca)_yCu_{3-y-k}O_f$, where k denotes a number between -0.05 and +0.05 and y denotes a number between 1 and 2.5, preferably 1.33 to 2.25, and f denotes 6+k, the Bi:Cu atomic ratio being 1:2 to 2:1 and the (Sr+Ca):Cu atomic ratio being 1:1 to 2:1, with an Sr/Ca atomic ratio of 1:9 to 9:1, a critical temperature $T_c$ for the superconductivity of at least 60 K and a principal phase which crystallizes in the orthorhombic system.

**2.** A crystalline substance as claimed in claim 1, where y denotes a number between 1.333 and 2.1, in particular 1.9 to 2.1.

**3.** A crystalline substance as claimed in claim 1, wherein k = 0.

**4.** A black crystalline substance with the overall composition
$Bi_a(Sr,Ca)_bCu_6O_x$, where

    a = 9.8 - 14 and
    b = 9.8 - 14,

with an Sr/Ca atomic ratio of 1:9 to 9:1, a Bi:(Sr+Ca) atomic ratio of 0.89 - 1.13, a critical temperature $T_c$ for the superconductivity of at least 60 K and a principal phase which crystallizes in the orthorhombic system.

5. A black compound which crystallizes in the orthorhombic system and has the overall composition $Bi_4(Sr,Ca)_4Cu_2O_{12}$ with an Sr:Ca atomic ratio of 9:1 to 1:9 and a critical temperature $T_c$ for the superconductivity of at least 60 K.

6. A compound as claimed in claim 5, wherein the Sr:Ca atomic ratio is 1:3 to 3:1.

7. A process for preparing superconducting substances or compounds containing bismuth, strontium, calcium and copper, which comprises preparing a mixture of the oxides of bismuth, calcium, strontium and copper or corresponding oxide precursors having a Bi:Cu atomic ratio of 1:2 to 2:1, a (Sr+Ca):Cu atomic ratio of 1:1 to 2:1, an Sr/Ca atomic ratio of 1:9 to 9:1 and a Bi:(Sr+Ca) atomic ratio of 0.3:1 to 1.3:1, heating the mixture high enough for all the components to be melted, cooling to temperatures of 300 - 900°C, keeping in this temperature range for at least one hour and then cooling further.

8. The process as claimed in claim 7, wherein salts of bismuth, calcium, strontium and copper, of which at least one is water-soluble, are mixed in the presence of an aqueous phase, and the mixture is evaporated down and heated.

9. The process as claimed in claim 7, wherein the isolated annealed metal oxide is comminuted, mixed and again heated in a temperature range of 300 to 900°C for at least 1 hour.

10. The process as claimed in claim 7, wherein the melt of the components is deposited on a substrate and allowed to solidify, and the solidified melt is heated at temperatures of 300 to 900°C, preferably 300 - 830°C.

11. The process as claimed in claim 10, wherein the melt is deposited in thin layers, in particular layers of 1 $\mu$m - 5 mm.

12. The process as claimed in claim 7, wherein the melt is spun to form filaments, and the filaments are allowed to solidify and are heated at temperatures of 300 - 900°C, preferably 300 - 830°C.

13. The process as claimed in at least one of claims 7, 9, 10, 11 and 12, wherein heating is carried out in an atmosphere which contains free oxygen.

14. The process as claimed in at least one of claims 7, 9, 10, 11 and 12, wherein cooling is carried out in an atmosphere containing oxygen.

15. A process for preparing superconducting substances or compounds containing bismuth, strontium, calcium and copper, which comprises preparing a mixture of the oxides of bismuth, calcium, strontium and copper or corresponding oxide precursors, the composition of which mixture in the triangular coordinate system lies between the points ABCD which define a parallelogram, where
A = $Bi_{0.19}E_{0.35}Cu_{0.46}$, B = $Bi_{0.14}E_{0.4}Cu_{0.46}$,
C = $Bi_{0.3}E_{0.38}Cu_{0.32}$, D = $Bi_{0.25}E_{0.43}Cu_{0.32}$ and E denotes the sum of the alkaline earths Ca+Sr, and the Ca/Sr atomic ratio is 0.85:1 - 1.2:1, in particular 0.95:1 - 1.1:1, heating the initial mixture of the oxides or oxide precursors to temperatures above 860°C but below the melting point in an atmosphere containing oxygen for at least 50 hours, then cooling to a temperature of 550 - 650°C, preferably 580 - 620, in particular 590 - 610°C, holding this temperature for at least 20 minutes and heating again to the sintering temperature, and repeating this procedure at least 2 ×.

16. The process as claimed in claim 15, wherein cooling and reheating is repeated 2 - 20 times.

17. The process as claimed in claim 15, wherein the time for cooling to 550 - 650°C, holding in the range 550 - 650°C and reheating to sintering temperatures is in each case at least 30 minutes, preferably at least 45 minutes.

18. The process as claimed in claim 17, wherein the time for cooling and holding at a temperature of 550 - 650°C is at least one hour in each case.

**Claims for the following Contracting States : ES, GR**

1. A process for preparing superconducting substances or compounds containing bismuth, strontium, calcium and copper, which comprises preparing a mixture of the oxides of bismuth, calcium, strontium and copper or corresponding oxide precursors having a Bi:Cu atomic ratio of 1:2 to 2:1, a (Sr+Ca): Cu atomic ratio of 1:1 to 2:1, an Sr:Ca atomic ratio of 1:9 to 9:1 and a Bi:(Sr+Ca) atomic ratio of 0.3 to 1.3:1, heating the mixture high enough for all the components be melted, cooling to temperatures of 300 - 900°C, keeping in this temperature range for at least one hour and then cooling further.

2. The process as claimed in claim 1, wherein salts of bismuth, calcium, strontium and copper, of which at least one is water-soluble, are mixed in the presence of an aqueous phase, and the mixture is evaporated down and heated.

3. The process as claimed in claim 2, wherein at least one metal hydroxide is precipitated by adding a base to the mixture of the salts in the presence of an aqueous phase, and the insoluble proportion is separated off, dried and heated.

4. The process as claimed in claim 2, wherein the salts used are derived from readily volatile acids.

5. The process as claimed in claim 1, wherein the isolated annealed metal oxide is comminuted, mixed and again heated in a temperature range of 300 to 900°C for at least 1 hour.

6. The process as claimed in claim 1, wherein the melt of the components is deposited on a substrate and allowed to solidify, and the solidified melt is heated at temperatures of 300 to 900°C, preferably 300 - 830°C.

7. The process as claimed in claim 6, wherein the melt is deposited in thin layers, in particular layers of 1 $\mu$m - 5 mm.

8. The process as claimed in claim 1, wherein the melt is spun to form filaments, and the filaments are allowed to solidify and are heated at temperatures of 300 - 900°C, preferably 300 - 830°C.

9. The process as claimed in at least one of claims 1, 5 and 8, wherein heating is carried out in an atmosphere which contains free oxygen.

10. The process as claimed in claim 1, wherein cooling is carried out in an atmosphere containing oxygen.

11. A process for preparing superconducting substances or compounds containing bismuth, strontium, calcium and copper, which comprises preparing a mixture of the oxides of bismuth, calcium, strontium and copper or corresponding oxide precursors the composition of which mixture in the triangular coordinate system lies between the points ABCD which define a parallelogram, where A = $Bi_{0.19}E_{0.35}Cu_{0.46}$, B = $Bi_{0.14}E_{0.4}Cu_{0.46}$, C = $Bi_{0.3}E_{0.38}Cu_{0.32}$, D = $Bi_{0.25}E_{0.43}Cu_{0.32}$ and E denotes the sum of the alkaline earths Ca + Sr, and the Ca/Sr atomic ratio is 0.85:1 - 1.2:1, in particular 0.95:1 - 1.1:1, heating the initial mixture of the oxides or oxide precursors to temperatures above 860°C but below the melting point in an atmosphere containing oxygen for at least 50 hours, then cooling to a temperature of 550 - 650°C, preferably 580 - 620, in particular 590 - 610°C, maintaining this temperature for at least 20 minutes and heating again to the sintering temperature, and repeating this procedure at least 2 ×.

12. The process as claimed in claim 11, wherein the heating is carried out in an oxygen-containing atmosphere for at least 80 hours.

13. The process as claimed in claim 11, wherein cooling and reheating is repeated 2 - 20 times.

14. The process as claimed in claim 11, wherein the time for cooling to 550 - 650°C, holding in the range 550 - 650°C and reheating to the sintering temperature is in each case at least 30 minutes, preferably at least 45 minutes.

15. The process as claimed in claim 11, wherein the time for cooling and holding a temperature of 550 - 650°C is at least one hour in each case.

16. The process as claimed in claim 1, wherein a Bi:Cu atomic ratio of 2:(3-y+k), a (Sr+Ca): Cu atomic ratio of y:(3-y+k) and a Bi:(Sr+Ca) atomic ratio of 2:y are maintained, y being a number between 1 and 2.5 and k a number between -0.05 and +0.05.

17. The process as claimed in claim 16, wherein k = 0.

**18.** A process for preparing superconducting substances or compounds containing bismuth, strontium, calcium and copper, by preparing a mixture of the oxides of bismuth, calcium, strontium and copper or corresponding oxide precursors and heating it, which comprises maintaining a Ca:Sr atomic ratio = 1:9 to 9:1, a Bi:Cu atomic ratio = 1.633 - 2.333, a (Sr+Ca):Cu atomic ratio = 1.633 - 2.333 and a Bi:(Sr+Ca) atomic ratio = 0.89 - 1.13, heating the mixture to temperatures of at least 700°C, so that the mixture is not melted or is only partially melted, keeping it in this temperature range for at least 4 hours and then cooling it.

## Revendications

**Revendications pour les Etats contractants suivants : AT, BE, CH, DE, FR, GB, IT, LI, LU, NL, SE**

**1.** Masse cristalline noire ayant une composition brute correspondant à $Bi_2(Sr,Ca)_yCu_{3-y-k}O_f$, où k représente un nombre compris entre -0,05 et +0,05 et y un nombre compris entre 1 et 2,5, de préférence de 1,33 à 2,25 et f représente 6+k, le rapport atomique Bi:Cu étant de 1:2 à 2:1 et le rapport atomique de (Sr+Ca):Cu de 1:1 à 2:1, avec un rapport atomique de Sr/Ca de 1:9 à 9:1, un point du changement brusque de la conductivité $T_c$ pour l'aptitude à la supraconductivité d'au moins 60 K et comportant une phase principale qui cristallise dans le système orthorhombique.

**2.** Masse cristalline noire selon la revendication 1, où y représente un nombre compris entre 1,333 et 2,1, notamment entre 1,9 et 2,1.

**3.** Masse cristalline noire selon la revendication 1, caractérisée en ce que k = 0.

**4.** Masse cristalline noire ayant une composition brute correspondant à $Bi_a(Sr,Ca)_bCu_6O_x$, où

a = 9,8 à 14 et
b = 9,8 à 14,

avec un rapport atomique de Sr/Ca de 1:9 à 9:1, un rapport atomique de Bi:(Sr+Ca) de 0,89 à 1,13, un point du changement brusque de la conductivité $T_c$ pour l'aptitude à la supraconductivité d'au moins 60 K et comportant une phase principale qui cristallise dans le système orthorhombique.

**5.** Composé noir, cristallisant dans le système orthorhombique, ayant une composition brute correspondant à $Bi_4(Sr,Ca)_4Cu_2O_{12}$ avec un rapport atomique de Sr:Ca de 9:1 à 1:9 et un point du changement brusque de conductivité $T_c$ pour l'aptitude à la supraconductivité d'au moins 60 K.

**6.** Composé selon la revendication 5, caractérisé en ce que le rapport atomique de Sr:Ca est de 1:3 à 3:1.

**7.** Procédé pour la préparation de composés ou de masses supraconductrices contenant du bismuth, du strontium, du calcium et du cuivre, caractérisé en ce qu'on chauffe un mélange d'oxydes de bismuth, de calcium, de strontium et de cuivre ou de précurseurs d'oxydes correspondants ayant des rapports atomiques de Bi:Cu de 1:2 à 2:1, de (Sr+Ca):Cu de 1:1 à 2:1, de Sr/Ca de 1:9 à 9:1 et de Bi:(Sr+Ca) de 0,3:1 à 1,3:1, à une température tellement élevée que tous les composants sont fondus, on refroidit à des températures de 300 à 900 °C, on maintient dans ce domaine de températures pendant au moins une heure et ensuite on refroidit encore.

**8.** Procédé selon la revendication 7, selon lequel on mélange les sels de bismuth, de calcium, de strontium et de cuivre, dont au moins un est hydrosoluble, en présence d'une phase aqueuse, on évapore le mélange et on chauffe.

**9.** Procédé selon la revendication 7, caractérisé en ce qu'on fragmente l'oxyde de métal isolé, ayant température équilibrée, on mélange et on chauffe encore une fois dans un domaine de température de 300 à 900 °C pendant au moins une heure.

**10.** Procédé selon la revendication 7, caractérisé en ce qu'on dépose la matière fondue des composants sur un substrat, on laisse solidifier et on chauffe la fonte solidifiée à des températures de 300 à 900 °C, de préférence de 300 à 830 °C.

**11.** Procédé selon la revendication 10, caractérisé en ce qu'on dépose la matière fondue sous forme de couches minces, plus particulièrement de couches d'une épaisseur de 1 $\mu$m à 5 mm.

**12.** Procédé selon la revendication 7, caractérisé en ce qu'on étire la fonte en fils, on laisse solidifier ces fils et on chauffe à des températures de 300 à 900 °C, de préférence de 300 à 830 °C.

**13.** Procédé selon au moins l'une des revendications 7, 9, 10, 11 et 12, caractérisé en ce qu'on chauffe sous une atmosphère contenant de l'oxygène libre.

**14.** Procédé selon au moins l'une des revendications 7, 9, 10, 11 et 12, caractérisé en ce qu'on refroidit sous une atmosphère contenant de l'oxygène.

**15.** Procédé pour la préparation de composés ou de masses supraconductrices contenant du bismuth, du strontium, du calcium et du cuivre, caractérisé en ce qu'on prépare un mélange des oxydes de bismuth, de calcium, de strontium et de cuivre ou des précurseurs d'oxydes correspondants, dont la composition se trouve dans le système de coordonnées triangulaires entre les points définissant un parallélogramme ABCD, où A = $Bi_{0,19}E_{0,35}Cu_{0,46}$, B = $Bi_{0,14}E_{0,4}Cu_{0,46}$, C = $Bi_{0,3}E_{0,38}Cu_{0,32}$, D = $Bi_{0,25}E_{0,43}Cu_{0,32}$, et E représente la somme des métaux alcalino-terreux Ca+Sr, et le rapport atomique de Ca/Sr est de 0,85:1 à 1,2:1, plus particulièrement de 0,95:1 à 1,1:1, on chauffe le mélange de départ des oxydes ou des précurseurs d'oxydes à des températures supérieures à 860 °C, mais inférieures au point de fusion, sous une atmosphère contenant de l'oxygène, pendant au moins 50 heures, on refroidit ensuite à une température de 550 à 650 °C, de préférence de 580 à 620 °C, plus particulièrement de 590 à 610 °C, on maintient pendant au moins 20 minutes à cette température et on chauffe encore une fois à la température de frittage et on répète au moins deux fois ce procédé.

**16.** Procédé selon la revendication 15, caractérisé en ce qu'on répète deux à vingt fois le refroidissement et le réchauffage.

**17.** Procédé selon la revendication 15 caractérisé en ce que le temps nécessaire pour le refroidissement à 550 à 650 °C, le maintien dans le domaine de températures de 550 à 650 °C et le réchauffage à la température de frittage soit chaque fois d'au moins 30 minutes, de préférence d'au moins 45 minutes.

**18.** Procédé selon la revendication 17, caractérisé en ce que le temps nécessaire au refroidissement et au maintien à une température de 550 à 650 °C dure au moins chaque fois une heure.

**Revendications pour les Etats contractants suivants : ES, GR**

**1.** Procédé pour la préparation de composés ou de masses supraconductrices contenant du bismuth, du strontium, du calcium et du cuivre, caractérisé en ce qu'on prépare un mélange d'oxydes de bismuth, de calcium, de strontium et de cuivre ou de précurseurs d'oxydes correspondants ayant des rapports atomiques de Bi:Cu de 1:2 à 2:1, de (Sr+Ca):Cu de 1:1 à 2:1, de Sr/Ca de 1:9 à 9:1 et de Bi:(Sr+Ca) de 0,3 à 1,3:1, on chauffe le mélange à une température tellement élevée que tous les composants sont fondus, on refroidit à des températures de 300 à 900 °C, on maintient dans ce domaine de températures pendant au moins une heure et on refroidit ultérieurement.

**2.** Procédé selon la revendication 1, caractérisé en ce qu'on mélange les sels de bismuth, de strontium, du calcium et du cuivre, dont au moins un est hydrosoluble en présence d'une phase aqueuse, on évapore le mélange et on chauffe.

**3.** Procédé selon la revendication 2, caractérisé en ce qu'on précipite au moins un hydroxyde métallique par addition d'une base au mélange des sels en présence d'une phase aqueuse, on sépare le composant insoluble, on sèche et on chauffe.

**4.** Procédé selon la revendication 2, caractérisé en ce que les sels utilisés dérivent des acides très volatils.

**5.** Procédé selon la revendication 1, caractérisé en ce qu'on fragment l'oxyde métallique isolé, ayant une température équilibrée, on le mélange et on chauffe encore une fois dans un domaine de températures de 300 à 900 °C pendant au moins une heure.

**6.** Procédé selon la revendication 1, caractérisé en ce qu'on dépose les composants fondus sur un substrat, on laisse solidifier et on chauffe la fonte solidifiée à des températures de 300 à 900 °C, de préférence de 300 à 830 °C.

**7.** Procédé selon la revendication 6, caractérisé en ce qu'on dépose la matière fondue sous forme de couches minces, plus particulièrement de couches d'une épaisseur de 1 $\mu$m à 5 mm.

8. Procédé selon la revendication 1, caractérisé en ce qu'on étire la matière fondue en fils, on laisse solidifier les fils et on chauffe à des températures de 300 à 900 °C, de préférence de 300 à 830 °C.

9. Procédé selon au moins l'une des revendications 1, 5 et 8 caractérisé en ce qu'on chauffe sous une atmosphère qui contient de l'oxygène libre.

10. Procédé selon la revendication 1, caractérisé en ce qu'on refroidit sous une atmosphère contenant de l'oxygène.

11. Procédé pour la préparation de composés ou de masses supraconductrices contenant du bismuth, du strontium, du calcium et du cuivre, caractérisé en ce qu'on prépare un mélange des oxydes de bismuth, de calcium, de strontium et de cuivre ou des précurseurs d'oxydes correspondants, dont la composition se trouve dans le système de coordonnées triangulaires entre les points définissant un parallélogramme ABCD, où A = $Bi_{0,19}E_{0,35}Cu_{0,46}$, B = $Bi_{0,14}E_{0,4}Cu_{0,46}$, C = $Bi_{0,3}E_{0,38}Cu_{0,32}$, D = $Bi_{0,25}E_{0,43}Cu_{0,32}$, et E représente la somme des métaux alcalino-terreux Ca+Sr, et le rapport atomique de Ca/Sr est de 0,85:1 à 1,2:1, plus particulièrement de 0,95:1 à 1,1:1, on chauffe le mélange de départ des oxydes ou des précurseurs d'oxydes à des températures supérieures à 860 °C mais inférieures au point de fusion, sous une atmosphère contenant de l'oxygène, pendant au moins 50 heures, on refroidit ensuite à une température de 550 à 650 °C, de préférence de 580 à 620 °C, plus particulièrement de 590 à 610 °C, on maintient pendant au moins 20 minutes à cette température et on chauffe encore une fois à la température de frittage et on répète au moins deux fois ce procédé.

12. Procédé selon la revendication 11, caractérisé en ce qu'on effectue le chauffage sous une atmosphère contenant de l'oxygène, pendant au moins 80 heures.

13. Procédé selon la revendication 11, caractérisé en ce qu'on répète le refroidissement et le réchauffage deux à vingt fois.

14. Procédé selon la revendication 11, caractérisé en ce que le temps nécessaire pour le refroidissement à 550 à 650 °C, le maintien dans le domaine de températures de 550 à 650 °C et le réchauffage à la température de frittage, soit chaque fois d'au moins 30 minutes, de préférence d'au moins 45 minutes.

15. Procédé selon la revendication 11, caractérisé en ce que le temps nécessaire au refroidissement et au maintien à une température de 550 à 650 °C, dure au moins chaque fois une heure.

16. Procédé selon la revendication 1, caractérisé en ce que on maintient un rapport atomique de Bi:Cu de 2:(3-y+k), un rapport atomique de (Sr+Ca):Cu de y:(3-y+k) et un rapport atomique de Bi:(Sr+Ca) de 2:y, où y représente un nombre compris entre 1 et 2,5 et k un nombre compris entre -0,05 et +0,05.

17. Procédé selon la revendication 16, caractérisé en ce que k = 0.

18. Procédé pour la préparation de composés ou de masses supraconductrices contenant du bismuth, du strontium, du calcium et du cuivre en péparant et en chauffant un mélange d' oxydes de bismuth, de calcium, de strontium et de cuivre ou de précurseurs d'oxydes correspondants caractérisé en ce qu'on maintient un rapport atomique de Ca:Sr = de 1:9 à 9:1, un rapport atomique de Bi:Cu = de 1,633 à 2,333, un rapport atomique de (Sr+Ca):Cu = de 1,633 à 2,333 et un rapport atomique de Bi:(Sr+Ca) = de 0,89 à 1,13, on chauffe le mélange à des températures d'au moins de 700°C, de sorte que le mélange n'est pas ou seulement en partie fondu, on maintient pendant au moins 4 heures dans ce domaine de températures et on refroidit ensuite.

# FIG. 1

$BiO_2-\delta$

$BiO_2-\delta$

$SrO$

$CuO_2$

$Ca, Sr$

$CuO_2$

$SrO$

$BiO_2-\delta$

$BiO_2-\delta$

# FIG. 2

Magnetfeld 100 G

EP 0 327 044 B2